Europäisches Patentamt

European Patent Office

Office européen des brevets

(11) Veröffentlichungsnummer: **0 480 205 A2**

## (12) EUROPÄISCHE PATENTANMELDUNG

(21) Anmeldenummer: **91115654.5**

(22) Anmeldetag: **16.09.91**

(51) Int. Cl.⁵: **G01R 31/308**, G01R 1/067

(30) Priorität: **09.10.90 DE 4032030**

(43) Veröffentlichungstag der Anmeldung:
**15.04.92 Patentblatt 92/16**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Sölkner, Gerald, Dr.**
**Naupliaallee 12**
**W-8012 Ottobrunn(DE)**

(54) Verfahren zur Messung elektrischer Potentiale in einem Halbleiter-Bauelement.

(57) Die optische Absorptionskante eines Halbleiters wird in einem elektrischen Feld zu kleineren Photonenenergien verschoben. Das erfindungsgemäße Verfahren nutzt diesen elektroabsorptiven Effekt, um elektrische Potentiale in Halbleiter-Bauelementen zu messen. Verwendet wird eine Lasersonde (LA), die man mit Hilfe einer Optik (L, OL) in die Ebene (FE) der signalführenden Elemente fokussiert. Da die von diesen Elementen ausgehenden elektrischen Streufelder das Absorptionsverhalten des Halbleitersubstrats lokal beeinflussen, lassen sich die entsprechenden Potentiale durch Messung der Intensität der reflektierten oder transmittierten Strahlung bestimmen. Eine große Tiefenauflösung der Messung wird durch einen konfokalen Strahlengang erreicht.

FIG 1

Das aus Electronics Letters Vol. 21, No. 13 (1985) Seiten 568 bis 579 bekannte Verfahren verwendet eine einseitig dielektrisch verspiegelte Kristallplatte mit elektrooptischen Eigenschaften, um die Potentialverteilung in Bauelementen der Mikroelektronik mit Hilfe einer Lasersonde abzubilden. Da man den von der Sonde punktweise abgetasteten Meßsensor unmittelbar oberhalb des Bauelements anordnet, können die von den Leiterbahnen ausgehenden elektrischen Streufelder in den Kristall eindringen und in diesem Doppelbrechung induzieren. Die hierdurch bedingte Änderung der Polarisation der den Kristall im Streufeldbereich durchsetzenden Laserstrahlung wird in einer Analysatoreinheit nachgewiesen und in Abhängigkeit vom Ort des Laserfokus auf der Bauelementoberfläche aufgezeichnet.

Während die aus Electronics Letters Vol. 20, No. 20 (1984), Seiten 818 und 819, Appl. Phys. Letters 47 (10), 1985, Seiten 1083 bis 1084 und US-A-4 681 449 bekannten Meßverfahren die elektrooptischen Eigenschaften des Substratmaterials zur Aufzeichnung von Signalpegeländerungen in Ga-As-Schaltungen ausnutzen, verwendet das in Electronics Letters, Vol. 22, No. 17 (1986), Seiten 918 bis 919 und US-A-4 618 819 beschriebene Verfahren eine $LiTaO_3$-Kristallspitze, um die im Bereich der Leiterbahnen auftretenden elektrischen Felder mit Hilfe einer die Kristallspitze durchsetzenden Lasersonde stroboskopisch abzutasten.

Weitere Lasermeßverfahren werden in IEEE Journal of Quantum Electronics Vol. 22, No. 1, 1986, Seiten 69 bis 78 beschrieben.

Der Erfindung liegt die Aufgabe zugrunde, ein Verfahren der Eingangs genannten Art anzugeben, mit dem Potentiale in Bauelementen der Mikroelektronik mit großer Genauigkeit gemessen werden können. Diese Aufgabe wird erfindungsgemäß durch ein Verfahren mit den Merkmalen des Patentanspruchs 1 gelöst.

Der mit der Erfindung erzielbare Vorteil besteht insbesondere darin, daß die Potentialverteilung in dreidimensional integrierten Strukturen mit einer hohen Tiefenauflösung abgebildet werden kann.

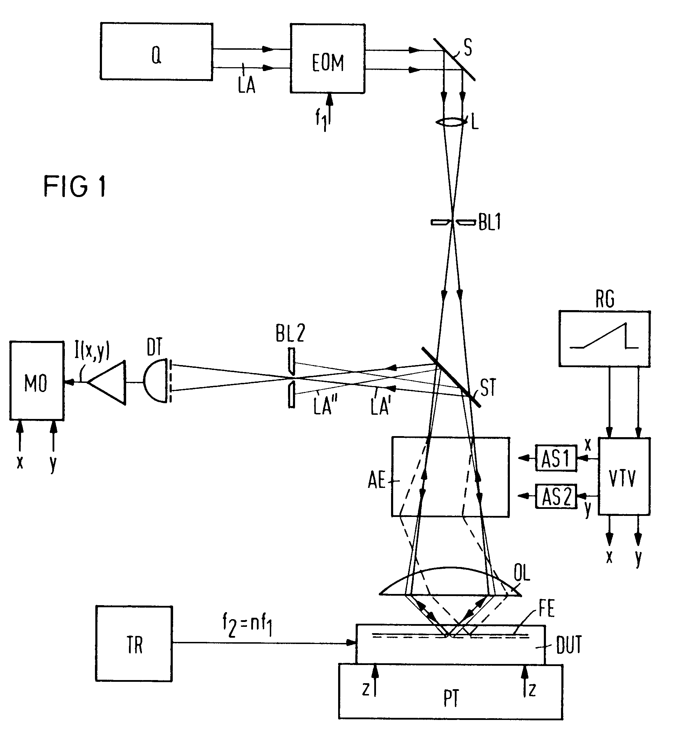

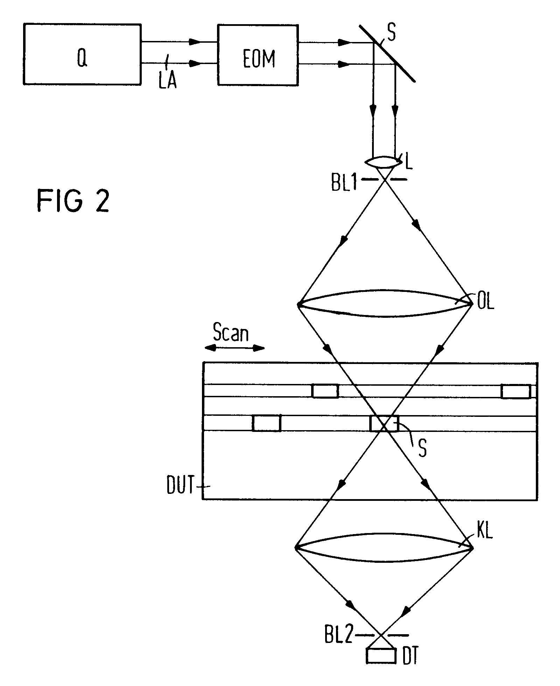

Die abhängigen Ansprüche betreffen vorteilhafte Weiterbildungen des im folgenden anhand der Zeichnung erläuterten Verfahrens. Hierbei zeigen die Figuren 1 und 2 Vorrichtungen zur Durchführung des Verfahrens.

Die optische Absorptionskante eines Halbleiters wird in einem elektrischen Feld zu kleineren Photonenenergien verschoben (Franz-Keldysh-Effekt). Das erfindungsgemäße Verfahren nutzt diesen elektrabsorptiven Effekt, um elektrische Potentiale mit Hilfe einer das zu untersuchende Bauelement abtastenden Lasersonde zu messen. Die Wellenlänge der Lasersonde ist hierbei derart auf die Absorptionskante des Substratmaterials abgestimmt, daß jede Potentialänderung eine möglichst große Änderung der Intensität der reflektierten oder transmittierten Strahlung hervorruft. Dies ist insbesondere dann gewährleistet, wenn die Photonenenergie $E_{Ph}$ der Bedingung $E_{Ph} \lesssim E_B$ und $|E_{Ph} - E_B| \approx 0$ ($E_B$: Bandabstand des Halbleitersubstrats) genügt.

Als Lichtquelle verwendet die in Fig. 1 dargestellte Vorrichtung zur Abbildung der Potentialverteilung in einem Halbleiter-Bauelement DUT einen durchstimmbaren Laser Q, dessen Strahlung LA einem elektrooptischen Modulator EOM zugeführt, an einem Spiegel S umgelenkt und mit Hilfe einer Linse L in die Ebene einer Lochblende BL1 fokussiert wird. Deren als punktförmige Lichtquelle dienende Öffnung bildet die Objektivlinse OL verkleinert in eine parallel zur Oberfläche des Bauelements DUT orientierte Ebene FE ab, wobei die Position des Laserfokus in dieser Ebene FE durch die aus zwei hochgenauen Galvanometerspiegeln bestehende Ablenkeinheit AE vorgegeben wird. Die die Strahlposition definierenden Ablenkspannungen erzeugt man in einem Rastergenerator RE, dessen in einem Tandemverstärker VTV verstärkten Ausgangssignale x bzw. y an den Eingängen der den Galvanometerspiegeln zugeordneten Ansteuereinheiten AS1 und AS2 anliegen. Durch Aktivierung der für die vertikale Verschiebung verantwortlichen Elemente des Positioniertisches PT kann die Lage der Fokussierungsebene FE innerhalb des Bauelements DUT eingestellt und geändert werden.

Des weiteren enthält die Vorrichtung einer Treibereinheit TR, die das Bauelement DUT zur periodischen Abarbeitung eines Testprogramms veranlaßt. Falls die durch die Treibereinheit TR vorgebbare Ansteuerfrequenz $f_2 = nf_1$ einem ganzzahligen Vielfachen n der Wiederholfrequenz $f_1$ der Laserimpulse entspricht, werden die während eines Testzyklus auftretenden Bauelementsignale innerhalb jeder n-ten Periode phasenstarr abgetastet (Stroboskopieprinzip).

Da die von signalführenden Elementen ausgehenden elektrischen Streufelder das Absorptionsverhalten des Halbleitersubstrats lokal beeinflussen, lassen sich die entsprechenden Potentiale durch Messung der Intensität der reflektierten Strahlung LA' bestimmen. Diese wird in dem gezeigten Ausführungsbeispiel durch die Objektivlinse OL kollimiert und mit Hilfe eines Strahlteilers ST in Richtung einer Photodiode DT umgelenkt. Die dem Detektor DT vorgelagerte Lochblende BL2 ist hierbei derart im Strahlengang angeordnet, daß nur die in der Brennebene FE reflektierte Strahlung LA' zum Meßsignal beiträgt (konfokaler Strahlengang). Die von außerhalb der Ebene FE kommende Strahlung LA'' verletzt die Fokussierungsbedingung und gelangt daher nicht zum Detektor DT. Dessen der Intensität proportionales Ausgangssignal I (x, y) wird verstärkt und in Abhängigkeit vom Ort des Laserfokus in der Brennebene FE aufgezeichnet bzw. zur Modulation der Helligkeit eines Bildpunktes auf dem Sichtgerät MO herangzogen.

In der in Fig. 2 schematisch dargestellten Vorrichtung ist ebenfalls ein konfokaler Strahlengang verwirklicht, um die Potentialverteilung in einem sogenannte Multilayer-Strukturen aufweisenden Bauelement DUT mit einer hohen Tiefenauflösung abzubilden. Die Vorrichtung enthält wiederum einen durchstimmbaren Laser Q, dessen Strahlung LA einem elektrooptischen Modulator EOM zugeführt, an einem Spiegel S umgelenkt und mit Hilfe einer Linse L in die Ebene einer als punktförmige Lichtquelle dienenden Lochblende BL1 fokussiert wird. Die konfokale Optik besteht in dem gezeigten Ausführungsbeispiel aus zwei Linsen OL und KL, wobei die Objektivlinse OL die Öffnung der Blende BL1 verkleinert in die Ebene der signalführenden Strukturen S abbildet. Die unterhalb des Bauelements DUT angeordnete Kollektorlinse KL dient der Bündelung der transmittierten Laserstrahlung, deren Intensität sich entsprechend den im Bereich des Laserfokus vorhandenen Streufeldern ändert.

Als Detektor zum Nachweis der durch feldinduzierte Absorption hervorgerufenen Intensitätsänderungen findet eine Photodiode DT Verwendung, der ein der Kontrastverbesserung dienende Lochblende BL2 vorgelagert ist. Die für eine flächenhafte Abtastung des Potentials erforderliche Horizontalverschiebung des Bauelements DUT im Laserstrahl wird mit Hilfe eines beispielsweise aus Scanning Vol. 7, No. 2 (1985), Seite 67 bekannten Positioniertisches vorgenommen.

Die mit der beschriebenen Vorrichtung erreichbare Ortsauflösung hängt im wesentlichen von der Wellenlänge der zu verwendeten Laserstrahlung und damit vom Substratmaterial und dessen Bandabstand ab. Für die Abbildung der Potentialverteilung in Ga-As-Schaltungen ist Infrarotstrahlung der Wellenlänge $\lambda \approx 850$ nm erforderlich, so daß die Ortsauflösung lateral maximal etwa 0,5 $\mu$m und in vertikaler Richtung etwa 0,7 $\mu$m beträgt.

Die Erfindung ist selbstverständlich nicht auf die beschriebenen Ausführungsbeispiele beschränkt. So ist es ohne weiteres möglich, auch die Zeitabhängigkeit des Potentials einer Meßstelle durch Anwendung eines Sampling-Verfahrens zu bestimmen. Die Phasenlage der Laserimpulse bezüglich der Bauelementsignale kann hierbei durch Verlängerung des Strahlengangs zwischen dem elektrooptischen Modulator EOM und dem Bauelement DUT oder durch Versatz der Ansteuerfrequenz $f_2$ gegenüber der Laser-Impulswiederholfrequenz $f_1$ geändert werden ($f_2 = n\,f_1 \pm \Delta f$, $\Delta f \ll f_1$). Die Vorrichtung zur Durchführung eines solchen Verfahrens enthält neben den schon beschriebenen Komponenten zusätzlich noch ein Sampling-Oszilloskop, an dessen Eingängen das verstärkte Detektorausgangssignal und ein die Abtastfrequenz $\Delta f$ aufweisendes Referenzsignal anliegt. Dieses Referenzsignal erzeugt man vorzugseise in einem Synthesizer, der ebenso wie die Treibereinheit TR und der elektrooptische Modulator EOM mit Hilfe eines phasenstabilen Oszillators synchronisiert wird.

Den Laser und den elektrooptischen Modulator kann man selbstverständlich auch durch eine Pikosekunden-Laserquelle ersetzen. Außerdem kann ein im Strahlengang oberhalb des Bauelements angeordneter frequenzverdoppelnder Kristall von Vorteil sein, um die Wellenlänge der Laserstrahlung besser auf die Absorptionskante des Halbleitersubstrats abzustimmen.

**Patentansprüche**

1. Verfahren zur Messung elektrische Potentiale in einem Halbleiter-Bauelement,
   **dadurch gekennzeichnet,**
   daß eine Lichtsonde (LA) auf eine parallel zur Oberfläche des Bauelements (DUT) orientierte Ebene (FE) fokussiert wird und daß die durch elektrische Potentiale induzierte Änderung des Absorptionsverhaltens des Halbleitermaterials durch Messung der Intensität der transmittierten oder reflektierten Strahlung (LA') bestimmt wird.

2. Verfahren nach Anspruch 1,
   **dadurch gekennzeichnet,**
   daß Licht verwendet wird, dessen Photonenenergie kleiner und annähernd gleich ist dem Bandabstand des Halbleitermaterials.

3. Verfahren nach Anspruch 1 oder 2,
   **dadurch gekennzeichnet,**
   daß der Fokus der Lichtsonde kontinuierlich oder in diskreten Schritten in der Ebene (FE) verschoben wird und daß die Intensität ortsabhängig bestimmt und aufgezeichnet wird.

4. Verfahren nach einem der Ansprüche 1 bis 3,
   **dadurch gekennzeichnet,**
   daß die Lichtsonde synchron mit einem im Bauelement (DUT) angeregten elektrischen Signal eingetastet wird.

5. Verfahren nach Anspruch 4,
   **dadurch gekennzeichnet,**
   daß die Phasenlage der Lichtimpulse bezüglich des Signals geändert wird.

6. Verfahren nach einem der Ansprüche 1 bis 5,
   **dadurch gekennzeichnet,**
   daß eine einen konfokalen Strahlengang aufweisende optische Einheit zur Erzeugung der Lichtsonde und zum Nachweis der reflektierten oder transmittierten Strahlung verwendet wird.

FIG 1

FIG 2